# EUROPEAN PATENT APPLICATION

(11) **EP 1 408 508 A1**
(43) Date of publication of application: **14.04.2004**
(21) Application number: 01948053.2
(22) Date of filing: 17.07.2001
(51) Int. Cl.: G11C 7/00, G06F 12/00

(54) **STORAGE DEVICE**

(71) Applicant: MITSUBISHI DENKI KABUSHIKI KAISHA, Tokyo 100-8310 (JP)
(72) Inventor: YAMAZAKI, Satoshi, Chiyoda-ku, Tokyo 100-8310 (JP)
(74) Representative: Meissner, Bolte & Partner
(86) International application number: PCT/JP2001/006191
(87) International publication number: WO 2003/009301

(57) **Abstract**

Upon receiving a data transfer command via an input/output buffer (23), a command analysis/control unit (24) transfers data in a memory cell array (21) to a second data register (25). An address conversion unit (26) converts a logical address input from a CPU (1) into the physical address of the second data register (25) to provide the converted address to said data register (25). Therefore, the CPU (1) can gain random access to the second data register (25). As a result, the CPU (1) can gain random access to the memory cell array (21). The processing speed of an apparatus incorporating the storage apparatus such as a cellular phone can be improved.

## Description

### Technical Field

The present invention relates to a storage apparatus used in cellular phones and the like, particularly to a storage apparatus transferring data in series.

### Background Art

In accordance with the broad usage of cellular phones, the demand for smaller cellular phones with multi functional capabilities is further increasing. To meet the demands for a smaller cellular phone, it is necessary to increase the integration density of the LSI (Large Scale Integrated Circuit) incorporated in the cellular phone to reduce the number of LSIs as well as reducing the number of pins of the LSIs to achieve a smaller chip size. In order to meet the demands for a multifunctional cellular phone, the application processing speed must be improved.

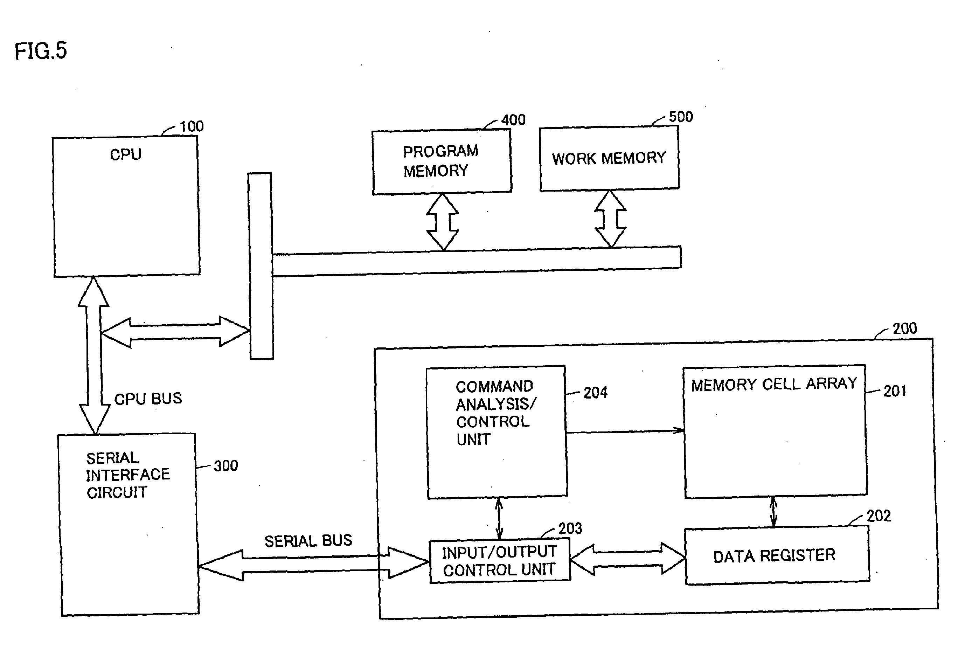

Fig. 5 shows an example of a circuit structure of a conventional cellular phone. This cellular phone includes a CPU (Central Processing Unit) 100 providing overall control of the cellular phone, a storage apparatus 200 in which applications, moving pictures, and the like are stored, a serial interface circuit 300 that inputs/outputs serial data to/from storage apparatus 200, a program memory 400 in which is stored a program that realizes the main function of the cellular phone, and a work memory 500 used as a work area.

In the case where CPU 100 is to access program memory 400 or work memory 500, access is established through a CPU bus that is a parallel bus. In the case where CPU 100 is to access storage apparatus 200, access is allowed by the serial/parallel conversion of serial interface circuit 300.

Storage apparatus 200 includes a memory cell array 201 in which are stored an application program that is user data as well as motion picture data, a data register 202 where data is temporarily stored at the time of access to memory cell array 201, an input/output control unit 203 transferring serial data with serial interface circuit 300, and a command analysis/control unit 204 analyzing a command input via input/output control unit 203 to provide entire control of storage apparatus 200. Memory cell array 201 is formed of an NAND type or AND type flash memory.

In the case where CPU 100 writes data into storage apparatus 200, CPU 100 issues a write command to serial interface circuit 300 via a CPU bus. Then, the address of memory cell array 201 and write data are provided to serial interface circuit 300. Upon receiving the write command from CPU 100, the address in memory cell array 201 and write data, serial interface circuit 300 converts the same into serial data. The converted serial data is provided to input/output control unit 203.

Input/output control unit 203 converts the write command from serial interface circuit 300 and the address of memory cell array 201 into parallel data. The converted parallel data is provided to command analysis/control unit 204. Also, input/output control unit 203 converts the write data from serial interface circuit 300 into parallel data. This converted parallel data is written into a data register 202.

Upon analyzing the command from input/output control unit 203 and confirming that the received command is a write command, command analysis/control unit 204 provides an address to memory cell array 201, and writes the write data stored in data register 202 into memory cell array 201.

In the case where CPU 100 is to read out data from storage apparatus 200, CPU 100 issues a read command to serial interface circuit 300 via the CPU bus. Then, the address of memory cell array 201 is provided to serial interface circuit 300. Upon receiving the read command from CPU 100 and the address of memory cell array 201, serial interface circuit 300 converts the same into serial data. This converted serial data is provided to input/output control unit 203.

Input/output control unit 203 converts the read command from serial interface circuit 300 and the address of memory cell array 201 into parallel data. This converted parallel data is provided to command analysis/control unit 204. Upon analyzing the command from input/output control unit 203 and confirming that it is a read command, command analysis/control unit 204 outputs the address to memory cell array 201. Data is read out from memory cell array 201 and written into data register 202.

Input/output control unit 203 reads out the data in data register 202 and converts the read out data into serial data. This converted serial data is provided to serial interface circuit 300. Serial interface circuit 300 converts the serial data from input/output control unit 203 into parallel data. This converted parallel data is provided to CPU 100 as read data.

Although an application program, motion picture data and the like are stored in storage apparatus 200 as user data, a read command must be issued to read out data in the case where CPU 100 is to read out data from storage apparatus 200. CPU 100 cannot achieve random access to the data stored in storage apparatus 200. In the case where an application program stored in storage apparatus 200 is to be executed, the application program must first be transferred to a storage apparatus that allows random access. The application program can be executed only after being transferred. Thus, there was a problem that the processing speed is degraded.

Since data of the storage apparatus is input/output in a serial manner, time is required to exchange the application program, motion picture and the like stored in the storage apparatus. Thus, the processing speed is degraded.

Furthermore, since CPU 100 cannot achieve random access to the data stored in storage apparatus 200, program memory 400 storing the program that realizes the major function of a cellular phone cannot be united with memory cell array 201 in storage apparatus 200. There was a problem that the cost of the components and the mounting area could not be reduced.

The present invention is directed to solve the above problems, and the first object is to provide a storage apparatus that can improve the processing speed of a cellular phone and the like.

The second object is to provide a storage apparatus that can reduce the cost and mounting area of the components in a device such as a cellular phone.

### Disclosure of the Invention

According to an aspect of the present invention, a storage apparatus includes a memory cell array, a data register temporarily storing data of the memory cell array and that allows parallel access from an external source, an input/output buffer converting externally applied serial data into parallel data, a command analysis/control unit analyzing a command converted into parallel data by the input/output buffer to provide control of data transfer between the memory cell array and the data register, and an address conversion unit converting an externally applied logical address into a physical address of the data register to provide the converted address to the data register.

Since the address conversion unit converts an externally applied logic address into a physical address of the data register to provide the converted address thereto, an external CPU can achieve random access to the data register. As a result, the external CPU can achieve random access to the memory cell array. The processing speed of an apparatus incorporating the storage apparatus such as a cellular phone can be improved. Since an external CPU can achieve random access to the memory cell array, a program or the like that realizes the major function can be stored in the memory cell array. The cost and mounting area of components in the apparatus such as a cellular phone can be reduced.

Preferably, the storage apparatus includes an address conversion table in which are registered a logical head address and logical end address of the memory cell array as well as the physical head address of the data register for each memory cell array region. The address conversion unit calculates the physical address of the data register based on the subtraction result between an externally applied logical address and a logical head address registered in the address conversion table, the subtraction result between the logical end address registered in the address conversion table and the externally applied logical address, and the physical head address registered in the address conversion table.

Therefore, an externally applied logical address can readily be converted into the physical address of the data register.

Preferably, the storage apparatus further includes a data buffer besides the data register, temporarily storing data of the memory cell array. The input/output buffer converts the data stored in the data buffer into serial data, and outputs the converted serial data to an external source.

Therefore, the data stored in the memory cell array can be converted into serial data to be output to an external source.

Further preferably, the command analysis/control unit responds to a first data transfer command from the input/output buffer to transfer the data in the memory cell array to the data buffer, and then transfer the data stored in the data buffer to the data register.

Since the data in the memory cell array is transferred to the data register, the data in the memory cell array can be accessed randomly by gaining access to the data register.

Further preferably, the command analysis/control unit responds to a second data transfer command from the input/output buffer to transfer data in the data register to the data buffer, and then transfer the data stored in the data buffer to the memory cell array.

Therefore, the data in the data register rewritten by an external CPU can be written back into the memory cell array.

According to another aspect of the present invention, a method of controlling a storage apparatus including a memory cell array, and a data register that temporarily stores the data of the memory cell array, and that allows parallel access from an external source includes the steps of converting externally applied serial data into a command of parallel data, analyzing the command to control data transfer between the memory cell array and the data register, and converting an externally applied logical address into a physical address of the data register to provide the converted address to the data register.

Since an externally applied logical address is converted into a physical address of the data register to be provided thereto, an external CPU can achieve random access to the data register. As a result, the external CPU can achieve random access to the memory cell array. The processing speed of an apparatus incorporating the storage apparatus such as a cellular phone can be improved. Since the external CPU can achieve random access to the memory cell array, a program or the like that realizes the main function can be stored in the memory cell array. The cost and mounting area of the components in the apparatus such as a cellular phone can be reduced.

Preferably, the step of converting an externally applied logical address into a physical address of the data register to provide the converted address to the data register includes the step of calculating the physical address of the data register based on the subtraction result between the externally applied logical address and a pre-registered logical head address of the memory cell array, the subtraction result between a pre-registered logical end address of the memory cell array and the externally applied logical address, and the pre-registered physical head address of the data register.

Therefore, the externally applied logic address can readily be converted into the physical address of the data register.

Preferably, the storage apparatus further includes a data buffer besides the data register to temporarily store data of the memory cell array. The storage apparatus control method further includes the step of converting the data stored in the data buffer into serial data for output.

Therefore, the data stored in the memory cell array can be converted into serial data to be output.

Further preferably, the step of analyzing a command to control data transfer between the memory cell array and the data register includes the step of transferring data in the memory cell array to the data buffer, and then transferring the data stored in the data buffer to the data register upon receiving a first data transfer command.

Since the data in the memory cell array is transferred to the data register, the data in the memory cell array can be accessed in random by an external CPU achieving access to the data register.

Further preferably, the step of analyzing a command to control data transfer between the memory cell array and the data register includes the step of transferring data in the data register to the data buffer, and then transferring the data stored in the data buffer to the memory cell array upon receiving a second data transfer command.

Therefore, the data in the data register rewritten by the external CPU can be written back into the memory cell array.

### Brief Description of the Drawings

Fig. 1 shows a circuit structure of a cellular phone according to an embodiment of the present invention.
Figs. 2A-2F are diagrams to describe a command sequence of a storage apparatus 2 according to an embodiment of the present invention.
Fig. 3 is a flow chart to describe the processing procedure of read data of storage apparatus 2 according to an embodiment of the present invention.
Fig. 4 is a flow chart to describe a processing procedure of write data of storage apparatus 2 according to an embodiment of the present invention;
Fig. 5 shows a circuit structure of a conventional cellular phone.

### Best Modes for Carrying Out the Invention

A detailed description of the present invention will be provided with reference to the appended drawings.

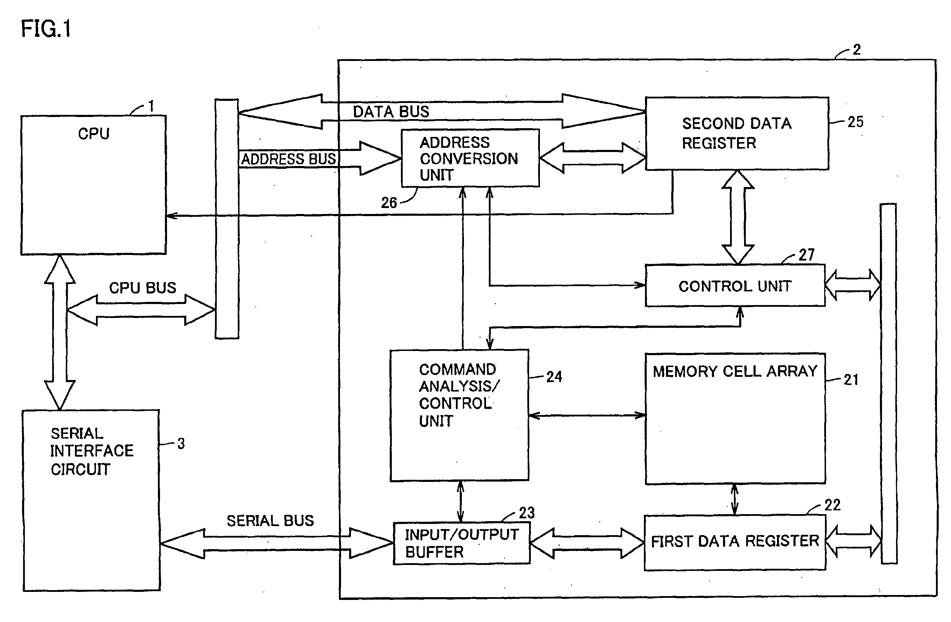

Fig. 1 shows a circuit structure of a cellular phone according to an embodiment of the present invention. This cellular phone includes a CPU 1 providing entire control of the cellular phone, a storage apparatus 2 in which are stored a program to realize the main function of the cellular phone, an application program, motion picture data, and the like, and a serial interface circuit 3 that inputs/outputs serial data to/from storage apparatus 2.

Storage apparatus 2 includes a memory cell array 21 in which are stored a program to realize the main function of a cellular phone, an application program that is user data, motion picture data, and the like, a first data register 22 where data is temporarily stored at the time of access to memory cell array 21, an input/output buffer 23 transferring serial data with serial interface circuit 3, a command analysis/control unit 24 analyzing a command input via input/output buffer 23 to provide entire control of storage apparatus 2, a second data register 25 where program and data are temporarily stored when CPU 1 conducts parallel access to the program and data stored in memory cell array 21, an address conversion unit 26 generating an address of second data register 25 when CPU 1 reads out the program or data stored in second data register 25, and a control unit 27 providing control of second data register 25 and address conversion unit 26 according to a designation from command analysis/control unit 24.

Memory cell array 21 is formed of a NAND or AND flash memory. This memory cell array 21 is formed of, but not limited to, a large flash memory of approximately 32 MB.

First data register 22 temporarily stores data in the case where CPU 1 reads out data from storage apparatus 2 via serial interface circuit 3, and when data stored in memory cell array 21 is to be transferred to second data register 25. This first data register is formed of, but not limited to, a SRAM (Static Random Access Memory) of approximately 512 bits. Data transfer between first data register 22 and memory cell array 22 is effected at one time in 512-bit unit.

Input/output buffer 23 buffers the serial data output from serial interface circuit 3 to convert the serial data into parallel data. Following transfer of data from first data register 22 to input/output buffer 23, input/output buffer 23 provides the buffered data to serial interface circuit 3 one bit at a time to convert the parallel data into serial data.

Second data register 25 temporarily stores data in the case where CPU 1 is to gain parallel access to the data stored in memory cell array 21. This second data register 25 is formed of a SRAM of approximately 2MB-8 MB. The data transfer between second data register 25 and first data register 21 is effected at one time in 512-bit unit under control of control unit 27.

Address conversion unit 26 converts the logical address of memory cell array 21 output from CPU 1 into a physical address of second data register 25. Address conversion unit 26 with an internal address conversion table converts the logical address into physical address based on the contents of the address conversion table. Memory cell array 21 is divided into a plurality of regions. The data in memory cell array 21 is mapped into second data register 25 in units of one such divided region.

In the address conversion table, the logical head address of the region in memory cell array 21 to be accessed by CPU 1, the logical end address of the region in memory cell array 21 to be accessed by CPU 1, the physical head address in second data register 25 in the case where the region in memory cell array 21 is to be copied to data register 25, and the physical end address of second data register 25 in the case where the region of memory cell array 21 is to be copied to second data register 25 are registered in advance for every region. Upon an output of a logical address from CPU 1, address conversion unit 26 carries out address conversion according to the following procedure.
① All the logical head addresses registered in the address conversion table are each subtracted from the logical address output from CPU 1.
② The logical address output from CPU 1 is subtracted from each of all the logical end addresses registered in the address conversion table.
③ The region where both the results of the above ① and ② become positive is identified, and the physical head address corresponding to the identified region is identified.
④ The subtraction result calculated at ① is added to the identified physical head address. The added result is output as the physical address in second data register 25.

Control unit 27 controls data copy between first data register 22 and second data register 25. In the case where data is to be copied from first data register 22 to second data register 25, command analysis/control unit 24 issues a data copy request from first data register 22 to second data register 25. Control unit 27 refers to the address conversion table in address conversion unit 26 to retrieve the physical head address of an empty region in second data register 25.

Control unit 27 transfers the data stored in first data register 22 into second data register 25 starting from the physical head address of the empty region in second data register 25. When all the data designated by command analysis/control unit 24 are transferred from first data register 22 to second data register 25, the physical head address and physical end address of the region in second data register 25 into which data is copied are registered in the address conversion table. Lastly, control unit 27 notifies command analysis/control unit 24 completion of data copy.

In the case where data is to be copied from second data register 25 to first data register 22, command analysis/control unit 24 issues a data copy request from second data register 25 to first data register 22. Control unit 27 copies the data in the specified region in second data register 25 into first data register 22. When data copy is completed, control unit 27 notifies command analysis/control unit 24 completion of data copy.

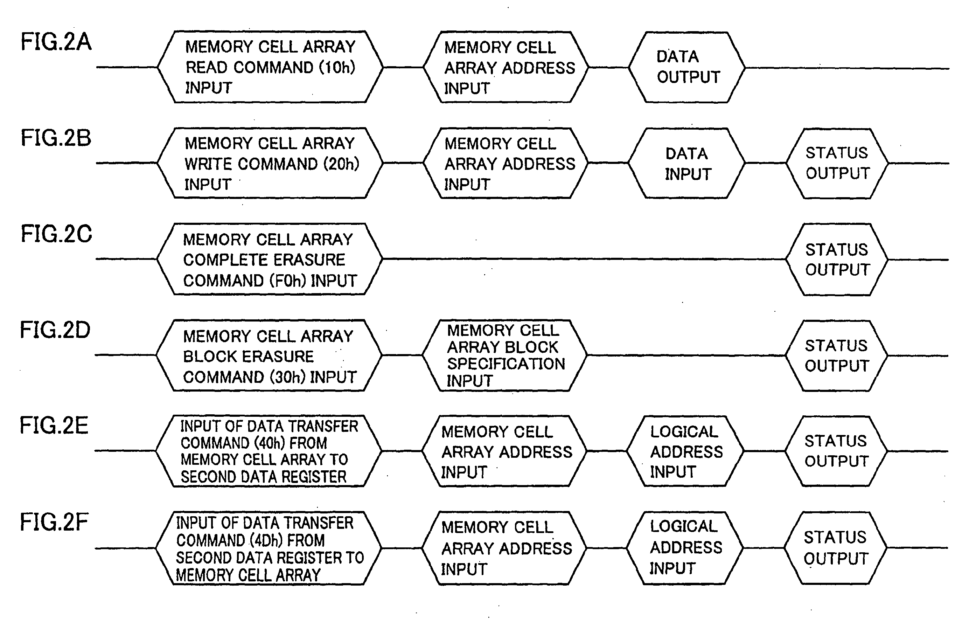

Figs. 2A-2F are diagrams to describe the command sequence of command analysis/control unit 24. Fig. 2A represents the command sequence of data read of memory cell array 21. When a data read command (10h) is input to command analysis/control unit 24 from input/output buffer 23 and an address of memory cell array 21 is input, command analysis/control unit 24 transfers the addressed data in memory cell array 21 to first data register 22. Then, command analysis/control unit 24 sequentially transfers the data stored in first data register 22 to input/output buffer 23, whereby serial data is output to serial interface circuit 3 via the serial bus.

Fig. 2B represents the data write command sequence of memory cell array 21. When a data write command (20h) and an address of memory cell array 21 are applied to command analysis/control unit 24 from input/output buffer 23, succeeding data is written into first data register 22. Command analysis/control unit 24 writes the data stored in first data register 22 into a specified address in memory cell array 21. Lastly, the status indicating whether the process has ended normally or not is provided to serial interface circuit 3.

Fig. 2C represents the entire erasure command sequence of memory cell array 21. When command analysis/control unit 24 receives an entire erasure command (F0h) from input/output buffer 23, command analysis/control unit 24 provides control so that all data in memory cell array 21 is erased. Lastly, the status indicating whether the process has ended normally or not is provided to serial interface circuit 3.

Fig. 2D represents the block erasure command sequence of memory cell array 21. When a block erasure command (30h) and a block specification of memory cell array 21 are applied to command analysis/control unit 24 from input/output buffer 23, command analysis/control unit 24 provides control on memory cell array 21 to erase data from the specified block in memory cell array 21. Lastly, the status indicating whether the process has ended normally or not is provided to serial interface circuit 3.

Fig. 2E represents the data transfer command sequence from memory cell array 21 to second data register 25. When command analysis/control unit 24 receives a data transfer command (40h) from memory cell array 21 to second data register 25, the address and logical address of memory cell array 21 from input/output buffer 23, command analysis/control unit 24 transfers the data corresponding to the specified address in memory cell array 21 to first data register 22. Then, command analysis/control unit 24 notifies control unit 27 a data copy request from first data register 22 to second data register 25. At this stage, command analysis/control unit 24 provides the specified logical address to address conversion unit 26. Lastly, the status indicating whether the process has ended normally or not is provided to serial interface circuit 3.

Fig. 2F represents the data transfer command sequence from second data register 25 to memory cell array 21. When command analysis/control unit 24 receives a data transfer command (4Dh) from second data register 25 to memory cell array 21, and the address and logical address of memory cell array 21 from input/output buffer 23, command analysis/control unit 24 provides the specified logical address to address conversion unit 26. Command analysis/control unit 24 notifies control unit 27 that data copy from second data register 25 to first data register 22 is requested. Then, the data stored in first data register 22 is transferred to the specified address in memory cell array 21. Lastly, the status indicating whether the process has ended normally or not is provided to serial interface circuit 3.

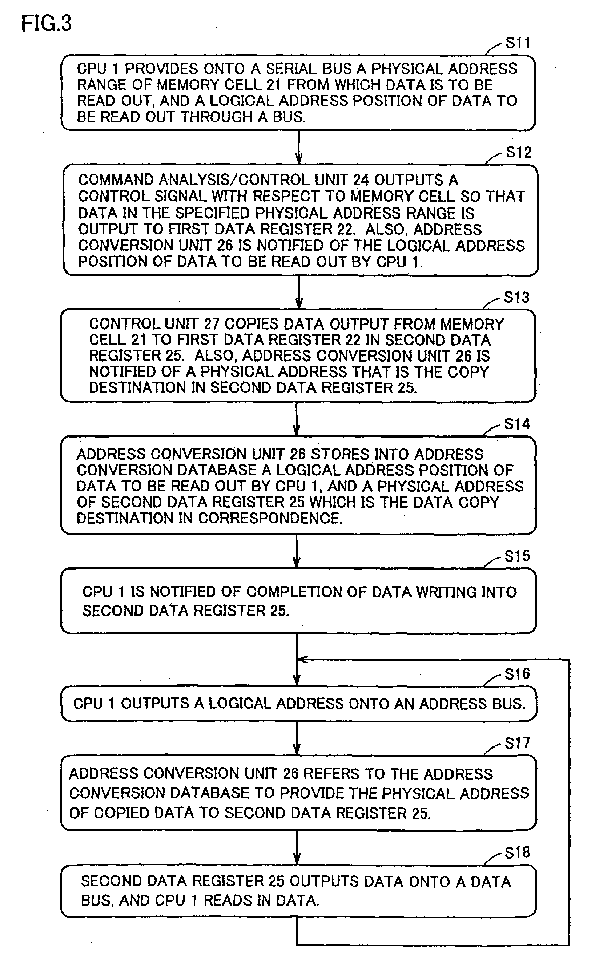

Fig. 3 is a flow chart to describe the read data processing procedure of storage apparatus 2 according to the embodiment of the present invention. CPU 1 provides to input/output buffer 23 via serial interface circuit 3 a data transfer command from memory cell array 21 to second data register 25, the physical address range in memory cell array 21, and the logical address of data to be read out via the CPU bus (S11).

Command analysis/control unit 24 provides control of memory cell array 21 to transfer the data in the specified physical address range to first data register 22, and provides the logical address of data that is to be read out via the CPU bus to address conversion unit 26 (S12).

Then, command analysis/control unit 24 causes control unit 27 to copy the data stored in first data register 22 to second data register 25, and provides the physical address that is the copy destination in second data register 25 to address conversion unit 26 (S13).

Address conversion unit 26 registers into the address conversion table the logical head address and logical end address of the region in memory cell array 21 to be accessed by CPU 1, and the physical head address and physical end address of second data register 25 that is the data copy destination in correspondence (S 14). Then, command analysis/control unit 24 notifies CPU 1 completion of data writing into data register 25 via input/output buffer 23 and serial interface circuit 3 (S15).

When CPU 1 outputs a logical address onto the address bus to gain access to second data register 25 (S16), address conversion unit 26 refers to the address conversion table to convert the logical address into the physical address of second data register 25 where data is copied. The converted physical address is provided to second data register 25 (S17). CPU 1 reads in the data output from second data register 25 via the CPU bus (S18). Then, control returns to step S16 to repeat the succeeding process.

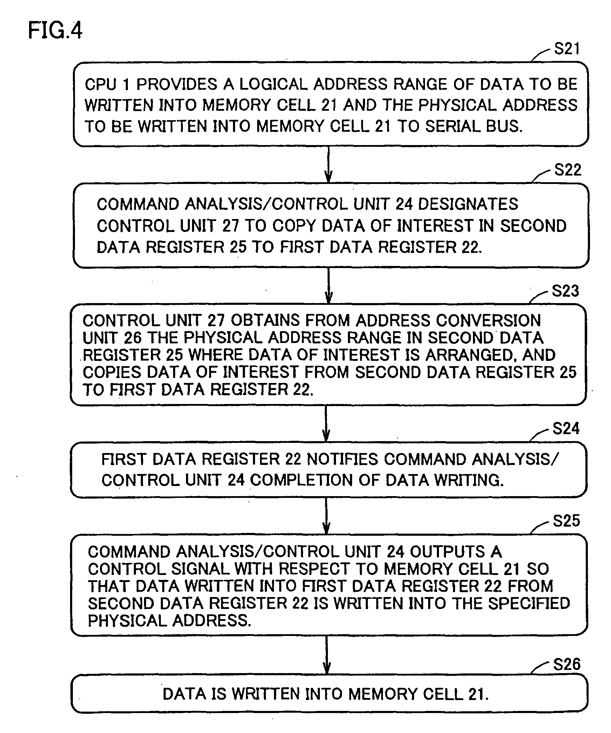

Fig. 4 is a flow chart to describe the write data processing procedure of storage apparatus 2 in the embodiment of the present invention. First, CPU 1 provides to input/output buffer 23 a command of data transfer from second data register 25 to memory cell array 21 via serial interface circuit 3, the logical address range of data to be written into memory cell array 21, and the physical address of memory cell array 21 (S21).

Command analysis/control unit 24 designates control unit 27 to copy the data in the second data register 25 to first data register 22 (S22). Control unit 27 obtains the physical address range in second data register 25 where the data of interest resides from address conversion unit 26, and the data of interest is copied from second data register 25 to first data register 22 (S23).

Upon completion of writing data into first data register 22, control unit 27 notifies command analysis/control unit 24 completion of data writing (S24). In response, command analysis/control unit 24 provides a control signal to memory cell array 21 (S25) so that the data written into the first data register 22 can be written into the specified physical address in memory cell array 21. Then, the data is written into memory cell array 21 (S26).

According to the present embodiment, a portion of data stored in a NAND or AND memory cell array 21 having a structure to which random access cannot be gained is transferred to second data register 25 such as a SRAM that has a random accessible structure in response to a serial input command. CPU 1 stores as the address conversion information the relationship between the logical address output when the transferred data is to be read out and the physical address of that transferred data in second data register 25. When a logical address is input to address conversion unit 26 from CPU 1 via an address bus, the relevant logical address is converted into the physical address in second data register 25 based on the address conversion information. The data stored in that physical address is transferred in parallel to CPU 1 via a data bus or the like.

According to the storage apparatus of the present embodiment, command analysis/control unit 24 transfers data from memory cell array 21 into accessible second data register 25 in parallel, and address conversion unit 26 converts the logical address output when CPU 1 is to gain access to memory cell array 21 into the physical address in second data register 25 to provide the converted address to second data register 25. Therefore, CPU 1 can gain random access to the data stored in memory cell array 21. The processing speed of an apparatus incorporating the storage apparatus such as a cellular phone can be improved.

Furthermore, since CPU 1 can gain random access to the data stored in memory cell array 21, the program or the like that realizes the main function of a cellular phone can be stored in memory cell array 21. It is no longer necessary to incorporate another program memory. Therefore, the cost and mounting area of components in a cellular phone or the like can be reduced.

The disclosed embodiment is only a way of example, and is not to be taken by way of limitation. The scope of the present invention is defined by the appended claims rather than by the description above. All changes that fall within metes and bounds of the claims or equivalence of such metes and bounds are therefore intended to be embraced by the claims.

## Claims

1. A storage apparatus comprising:
a memory cell array (21);
a data register (25) temporarily storing data of said memory cell array (21), and that can be accessed in parallel from an external source;
an input/output buffer (23) converting externally applied serial data into parallel data;
a command analysis/control unit (24, 27) analyzing a command converted into parallel data by said input/output buffer (23) to control data transfer between said memory cell array (21) and said data register (25); and
an address conversion unit (26) converting an externally applied logical address into a physical address of said data register (25), and providing said converted physical address to said data register (25).

2. The storage apparatus according to claim 1, further comprising an address conversion table in which are registered for every region of said memory cell array (21) a logical head address of said memory cell array (21), a logical end address of said memory cell array (21), and a physical head address of said data register (25),
wherein said address conversion unit (26) calculates a physical address of said data register (25) based on a subtraction result between an externally applied logical address and the logical head address registered in said address conversion table, a subtraction result between the logical end address registered in said address conversion table and said externally applied logical address, and the physical head address registered in said address conversion table.

3. The storage apparatus according to claim 1, further comprising a data buffer (22) besides said data register (25), temporarily storing data of said memory cell array (21),
wherein said input/output buffer (23) converts data stored in said data buffer (22) into serial data for output.

4. The storage apparatus according to claim 3, wherein said command analysis/control unit (24, 27) transfers data of said memory cell array (21) to said data buffer (22), and then transfers data stored in said data buffer (22) to said data register (25) upon receiving a first data transfer command from said input/output buffer (23).

5. The storage apparatus according to claim 3, wherein said command analysis/control unit (24, 27) transfers data of said data register (25) to said data buffer (22), and then transfers data stored in said data buffer (22) to said memory cell array (21) upon receiving a second data transfer command from said input/output buffer (23).

6. A method of controlling a storage apparatus including a memory cell array (21), and a data register (25) temporarily storing data of said memory cell array (21), and accessible in parallel from an external source, said storage apparatus control method comprising the steps of:
converting externally applied serial data into a command of parallel data;
analyzing said command to control data transfer between said memory cell array (21) and said data register (25); and
converting an externally applied logical address into a physical address of said data register (25), and providing said converted physical address to said data register (25).

7. The storage apparatus control method according to claim 6,
wherein said step of converting an externally applied logical address into a physical address of said data register (25), and providing said converted physical address to said data register (25) includes the step of calculating the physical address of said data register (25) based on a subtraction result between said externally applied logical address and a pre-registered logical head address of said memory cell array (21), a subtraction result between a pre-registered logical end address of said memory cell array (21) and said externally applied logical address, and a pre-registered physical head address of said data register (25).

8. The storage apparatus control method according to claim 6, wherein said storage apparatus further includes a data buffer (22) besides said data register (25) temporarily storing data of said memory cell array (21).
wherein said storage apparatus control method further includes the step of converting data stored in said data buffer (22) into serial data for output.

9. The storage apparatus control method according to claim 8, wherein said step of analyzing said command to control data transfer between said memory cell array (21) and said data register (25) includes the step of transferring data of said memory cell array (21) into said data buffer (22), and then transferring data stored in said data buffer (22) to said data register (25), upon receiving a first data transfer command.

10. The storage apparatus control method according to claim 8, wherein said step of analyzing said command to control data transfer between said memory cell array (21) and said data register (25) includes the step of transferring data of said data register (25) to said data buffer (22), and then transferring data stored in said data buffer (22) to said memory cell array (21) upon receiving a second data transfer command.
